Europäisches Patentamt

European Patent Office

Office européen des brevets

(19)

(11) Veröffentlichungsnummer: **0 096 820**
**B1**

(12) **EUROPÄISCHE PATENTSCHRIFT**

(45) Veröffentlichungstag der Patentschrift:
**28.01.87**

(21) Anmeldenummer: **83105564.5**

(22) Anmeldetag: **07.06.83**

(51) Int. Cl.⁴: **H 03 C 1/06**, H 03 F 1/32

(54) Hochfrequenzleistungsverstärker mit einer Modulationseinrichtung.

(30) Priorität: **11.06.82 DE 3221911**

(43) Veröffentlichungstag der Anmeldung:
**28.12.83 Patentblatt 83/52**

(45) Bekanntmachung des Hinweises auf die Patenterteilung:
**28.01.87 Patentblatt 87/5**

(84) Benannte Vertragsstaaten:
**DE FR GB NL**

(56) Entgegenhaltungen:
**EP - A - 0 039 080**
**DE - B - 2 835 751**
**US - A - 4 237 555**
**US - A - 4 291 277**

**Patent Abstracts of Japan Band 4, Nr. 67, 20. Mai 1980**
**Seite 82E11 & JP-A-55-35594**

(73) Patentinhaber: **International Standard Electric Corporation, 320 Park Avenue, New York New York 10022 (US)**

(84) Benannte Vertragsstaaten: **FR GB NL**

(73) Patentinhaber: **Standard Elektrik Lorenz Aktiengesellschaft, Hellmuth-Hirth-Strasse 42, D-7000 Stuttgart 40 (DE)**

(84) Benannte Vertragsstaaten: **DE**

(72) Erfinder: **Herzog, Georg, Rheingaustrasse 26, D-6802 Ladenburg (DE)**
Erfinder: **Fischer, Axel, Sofienstrasse 5, D-6842 Bürstadt (DE)**

(74) Vertreter: **Schmidt, Werner, Dipl.-Phys. et al, c/o Standard Elektrik Lorenz AG Patent- und Lizenzwesen Kurze Strasse 8 Postfach 300 929, D-7000 Stuttgart 30 (DE)**

**Beschreibung**

Die Erfindung geht aus von einem Hochfrequenzleistungsverstärker mit einer Modulationseinrichtung wie im Oberbegriff des Anspruchs 1 angegeben. Ein solcher Hochfrequenzleistungsverstärker ist aus der DE-C- 28 35 751 bekannt.

Bei dem dort beschriebenen Leistungsverstärker wird abhängig von einem Vergleich von Soll- und Ist-Signal ein erstes oder ein zweites Signal abgegeben. Dieses Signal gibt an, ob das Ist-Signal grösser oder kleiner als das Sollsignal ist. Mit dem dort beschriebenen Hochfrequenzleistungsverstärker kann ein Ist-Impuls dem Soll-Impuls sehr gut angepasst werden. Zur Anpassung des Ist- an den Soll-Impuls ist jedoch ein grosser Zeitaufwand notwendig, wenn das Istvom Sollsignal zu Beginn der Korrektur stark abweicht. Dies ist insbesondere häufig dann der Fall, wenn von einer ersten auf eine zweite Trägerfrequenz umgeschaltet wird.

Aus der US-A-4 291 277 ist ein digitales Nachrichtenübertragungssystem bekannt. Den digitalen Werten sind unterschiedliche Amplituden zugeordnet. Bei der Signalverstärkung verursachte Amplitudenverzerrungen machen sich bei der Signalübertragung störend bemerkbar. Deshalb erfolgt eine Vorverzerrung des Modulationssignals, das die zu übertragenden Daten enthält. Zur Gewinnung der erforderlichen Vorverzerrung erfolgt ein Vergleich der analogen Ist-Signale mit den analogen Soll-Signalen.

Aufgabe der Erfindung ist es, einen Hochfrequenzleistungsverstärker mit einer Modulationseinrichtung anzugeben, bei dem das Ist-Signal schnell an den Verlauf des Soll-Signals angepasst wird.

Die Lösung dieser Aufgabe erfolgt mit den im Anspruch 1 angegebenen Mitteln. Vorteilhafte Weiterbildungen sind den Unteransprüchen zu entnehmen.

Bei dem neuen Hochfrequenz-Leistungsverstärker erlangt das Ist-Signal sehr schnell die Form des Soll-Signals. Dies ist besonders dann von Vorteil, wenn von einer ersten auf eine zweite Trägerfrequenz umgeschaltet wird.

Gemäss einer Weiterbildung werden in den Fällen, in denen das Sendesignal nicht aus einzelnen Impulsen sondern aus Impulsgruppen besteht, für alle Impulse einer Impulsgruppe geeignet vorverzerrte Amplitudenwerte gespeichert. Dadurch werden unter anderem die Abweichungen kompensiert, die durch die sich in Abhängigkeit von der Pulsrate ändernden Verstärkung ergeben.

Bei Verwendung von Zwischenspeichern kann die Korrektur in den Pulspausen durchgeführt werden.

In diesem Fall ist die Regelschleife während der Korrektur unterbrochen und man erhält eine hohe Stabilität der gesamten Regelung.

Gemäss einer anderen Weiterbildung werden auch die Fehler, die in der Regelschleife bei der Bestimmung der Einhüllenden des ausgekoppelten Teils des Sendesignals (z.B. durch Gleichrichten) verursacht werden, kompensiert.

Eine Lösung zur Gleichrichtung, bei dieser mögliche Fehler, sehr gering gehalten wird, ist im letzten Unteranspruch angegeben.

Die Erfindung wird anhand der Zeichnungen beispielsweise näher erläutert. Es zeigt:

Fig. 1 ein Blockschaltbild des neuen Hochfrequenz-Leistungsverstärkers,

Fig. 2 ein Blockschaltbild eines neuen, in dem Hochfrequenz-Leistungsverstärker verwendeten Gleichrichters, und

Fig. 3 Diagramme zur Erläuterung der Funktionsweise des Gleichrichters nach Fig. 2.

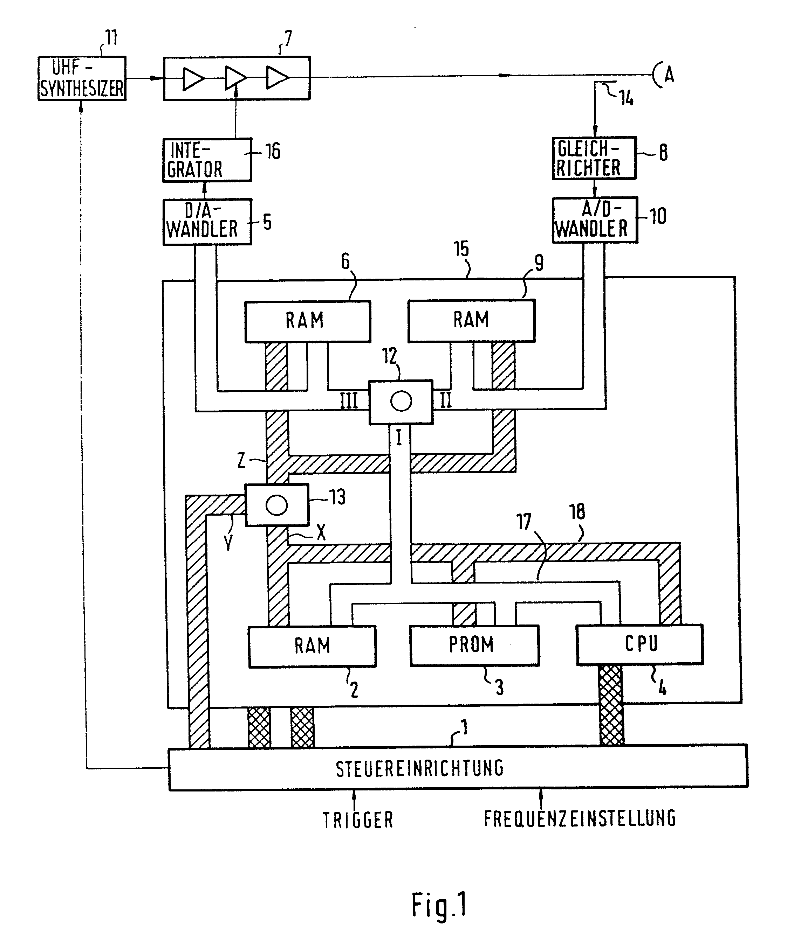

In der Fig. 1 ist ein Blockschaltbild des neuen Hochfrequenz-Leistungsverstärkers mit einer Modulationseinrichtung dargestellt. In einem UHF-Synthesizer 11 wird ein in einem mehrstufigen Leistungsverstärker 7 zu verstärkendes und zu modulierendes Hochfrequenzsignal erzeugt. Das verstärkte und impulsförmig modulierte Hochfrequenzsignal gelangt zu einem Ausgang A. Der Ausgang A kann direkt mit einer Antenne verbunden sein.

Ein Richtkoppler 14 koppelt einen Teil des Ausgangssignals des Leistungsverstärkers aus und führt diesen einem Gleichrichter 8 zu. Das Ausgangssignal des Gleichrichters 8 wird in einem Analog/Digital-Wandler 10 digitalisiert und das digitalisierte Signal wird einem Speicher mit wahlfreiem Zugriff (RAM) 9 gespeichert. Das digitale Signal, aus dem das Modulationssignal gebildet wird, ist in einem RAM 6 gespeichert. Nach seinem Auslesen aus dem RAM 6 gelangt es über einen Digital/Analog-Wandler 5 und einen Integrator 16 zu dem Hochfrequenzleistungsverstärker 7.

Anstelle des Integrators 16 kann auch ein Tiefpassfilter verwendet werden. Bei der Auswahl des Tiefpassfilters muss beachtet werden, dass die Zeitkonstante des Tiefpassfilters die Impulsform beeinflusst. Eine Verfälschung beim Ausgangssignal des Leistungsverstärkers wird hierdurch jedoch nicht verursacht, da durch die Regelung des Modulationssignal so vorverzerrt ist, dass störende Einflüsse, die innerhalb der Verstärkungs- und Modulationseinrichtung vorhanden sind, kompensiert werden.

Als Hochfrequenz-Leistungverstärker wird ein mehrstufiger Verstärker verwendet. Welcher Stufe das Modulationssignal zugeführt wird hängt von verschiedenen Kriterien ab. Bei Navigationseinrichtungen beispielsweise ist es wichtig, dass in den Seitenbändern des Pulsspektrums nur wenig Leistung erzeugt wird. Aus verschiedenen Gründen lässt sich dies dann besonders gut erreichen, wenn das Modulationssignal dem Verstärker nahe der Endstufe zugeführt wird.

Wie bereits erwähnt, sind die Amplitudenwerte des Ist-Signals, deren Einhüllende das Ist-Signal ergibt, in dem RAM 9 und die Amplitudenwerte des vorverzerrten Modulationssignals, im RAM 6 gespeichert. Die Amplitudenwerte, deren Einhüllende das Soll-Signal ergibt, sind in einem programmierbaren Lesespeicher PROM 3 gespeichert.

Durch Vergleich von Ist- und Soll-Signal erhält man Korrekturwerte, die dazu verwendet werden, das Modulationssignal so vorzuverzerren, dass das Ist-Signal den gewünschten Verlauf hat. Zur technischen Durchführung dieses Vergleichs gibt es unterschiedliche Lösungen. Einfach lassen sich der Vergleich und die Ermittlung der Korrekturwerte in einem Mikrorechner 15 realisieren. Wird ein Mikrorechner 15 verwendet, dann sind die RAM 6 und RAM 9 Bestandteile dieses Mikrorechners.

Die Funktion, der Aufbau und die einzelnen Bestandteile eines Mikrorechners sind dem Fachmann bekannt, so dass diese hier nicht näher erläutert werden brauchen. Es wird lediglich auf die Teile Bezug genommen, die zum Verständnis der Erfindung notwendig sind.

Die Steuerung des Mikrorechners erfolgt durch eine Steuereinrichtung 1, über die im Mikrorechner geeignete Programme ausgewählt werden, welche den internen Ablauf im Mikrorechner steuern. Die Steuereinrichtung 1 steuert weiterhin die Frequenz der im UHF-Synthesizer 11 erzeugten Trägerschwingung. Als Reaktion auf ihr zugeführte Triggersignale wird die Ausstrahlung eines impulsförmigen Signals (oder, wie weiter unten noch näher erläutert wird, von Impulsgruppen) ausgelöst.

In dem Mikrorechner 15 sind Datenbussysteme 17 und Adressbussysteme 18 vorgesehen. Ein Datenbussystem I verbindet einen RAM 2, den PROM 3 und die Zentraleinheit (CPU) 4 untereinander und mit einer Datenbusweiche 12; die Datenbusweiche 12 ist über ein weiteres Datenbussystem II mit dem RAM 9 und dem A/D-Wandler 10 verbunden; die Datenbusweiche 12 ist über ein Datenbussystem III mit dem RAM 6 und dem D/A-Wandler 5 verbunden. Ein Adressbussystem X verbindet den RAM 2, den PROM 3 und die CPU untereinander und mit einer Adressbusweiche 13; die Adressbusweiche 13 ist über ein Adressbussystem Z mit dem RAM 6 und dem RAM 9 sowie der Adressbusweiche 13 verbunden und über ein Adressbussystem Y ist die Steuereinrichtung 1 mit der Adressbusweiche 13 verbunden.

Nach Auslösen des Sendevorgangs durch die Steuereinrichtung 1 werden im Mikrorechner folgende Zustände hergestellt:

– der D/A-Wandler 5 und der A/D-Wandler 10 werden für den Sendebetrieb freigegeben,
– die Datenbusweiche 12 trennt die drei Datenbussysteme I, II, III voneinander,
– die Adressbusweiche 13 verbindet die Adressbussysteme Y und Z untereinander und trennt das Adressbussystem X von den anderen Adressbussystemen.

Dadurch wird verhindert, dass die CPU 4 auf die Speicher RAM 6 oder RAM 9 zugreift. Rechenvorgänge, die nur über die Speicher RAM 2 und PROM 3 abgewickelt werden, können während dieser Zeit ausgeführt werden.

Im PROM 3 sind mehrere Amplitudenwerte gespeichert, deren Einhüllende das Sollmodulationssignal ergeben. Zur Speicherung eines Amplitudenwerts ist jeweils ein Wort mit 8 Bit vorgesehen. Die gespeicherten Amplitudenwerte ergeben, wie in der zitierten DE-PS beschrieben, das Modulationssignal. Die Inhalte der RAM 6 und RAM 9 werden bit-parallel ein- bzw. ausgelesen.

Nach dem Sendevorgang werden, wie bereits erwähnt, die dem Sendesignal entsprechenden Amplitudenwerte im RAM (9) gespeichert.

Eine bestimmte Zeit nach dem Vorhandensein des Triggersignals, das über die Steuereinrichtung 1 den Sendevorgang auslöst, wird von der Betriebsart «Senden» auf die Betriebsart «Korrigieren» umgeschaltet. Die Zeit ist so gewählt, dass der Hochfrequenzverstärker 7 innerhalb dieser Zeit das verstärkte und modulierte Signal abgegeben hat.

Während der Betriebsart «Korrigieren» stellt die Steuereinrichtung 1 folgende Zustände her:
– der D/A-Wandler 5 und der A/D-Wandler 10 werden gesperrt,
– die Datenbusweiche 12 verbindet die Datenbussysteme I, II und III miteinander,
– die Adressbusweiche verbindet die Adressbussysteme X und Z miteinander. Das Adressbussystem Y ist von den anderen Adressbussystemen getrennt.
– die CPU 4 kann jetzt auf alle Speicher beliebig zugreifen.

Nachfolgend wird beschrieben, wann welche Werte ermittelt werden und wie die Vergleiche zur Bestimmung der Korrekturwerte durchgeführt werden.

Das Triggersignal löst den Sendevorgang aus. Mit dem ersten Triggersignal nach dem Einschalten der gesamten Einrichtung wird über die CPU 4 der Inhalt des RAM 6 gelöscht. Dementsprechend ist das Modulationssignal null und das gleichgerichtete, vom Richtkoppler 14 ausgekoppelte Signal ist ebenfalls null. Im RAM 9 werden somit ausschliesslich Werte null gespeichert.

Im PROM 3 sind die Amplitudenwerte des Sollimpulses gespeichert. Es wird jeder im PROM 3 gespeicherte Soll-Wert mit seinem entsprechenden Ist-Wert verglichen. Diese so ermittelte Differenz wird gespeichert; sie ist jedoch noch nicht der Wert, der als korrigierter Wert in den RAM 6 eingelesen wird.

Würde für die Korrektur eines gespeicherten Amplitudenwertes nur die für ihn ermittelte Differenz herangezogen, dann würden Fehler nicht erfasst, die durch den nichtlinearen Verlauf der Verstärkerkennlinie verursacht werden. Weiterhin muss die bei dem entsprechenden Amplitudenwert vorhandene Steilheitsdifferenz der Verstärkerkennlinie berücksichtigt werden.

Deshalb wird für die Bestimmung des Korrekturwertes für eine bestimmte gespeicherte Amplitude nicht nur für diesen Wert die Differenz von Soll- und Istwert berücksichtigt, sondern auch die Differenzen für die zeitlich nachfolgenden acht Amplitudenwerte. Ist kein weiterer Amplitudenwert mehr vorhanden, zum Beispiel am Ende eines Impulses, dann werden die nicht mehr ermittelbaren Differenzen gleich null gesetzt.

Als neuer Amplitudenwert verwendet man den Wert, der gebildet wird durch die Summe:

$$A + D - K1 + K2$$

mit

A: gespeicherter Amplitudenwert,

D: Ist-Wert minus Soll-Wert für den betroffenen Amplitudenwert,

K1: Parameter, abhängig von der Steilheit der Verstärkerkurve beim Wert des zu korrigierenden Amplitudenwerts (diese Werte liegen für einen gegebenen Verstärker fest und werden für den betroffenen Amplitudenwert dem Speicher PROM 3 entnommen).

K2: Parameter, der sich aus der kleinsten Differenz der nachfolgenden 8 Amplitudenwerte ergibt.

Der so neu ermittelte Amplitudenwert, der im wesentlichen bestimmt ist durch die vorhandene Differenz von Soll- und Ist-Wert, wird in den Speicher RAM 6 eingegeben.

Die hier für einen gespeicherten Amplitudenwert beschriebene Korrektur wird parallel für alle Amplitudenwerte durchgeführt. Damit wird erreicht, dass bereits das nach dem nächsten Triggerimpuls verwendete Modulationssignal so vorverzerrt ist, dass das Verstärkerausgangssignal bereits angenähert den vorgeschriebenen Verlauf hat. Nach wenigen Verstärkerdurchläufen ist das Ist- dem Soll-Signal angepasst. Die Vorgänge bei der Korrektur, bei denen auf die Speicherinhalte von RAM 6 und RAM 9 zurückgegriffen werden muss, können erst nach Abschluss des Sendevorgangs abgeschlossen werden.

Der Parameter K1 wird so gewählt, dass das Soll-Signal stets geringfügig grösser ist als das Ist-Signal.

Wenn nach einigen Sendezyklen das Ist-Signal die gewünschte Form erreicht hat, erfolgt eine vereinfachte Regelung, die der in der zitierten DE-PS ähnlich ist.

Nach jedem Triggersignal wird dann nur noch jeweils ein Amplitudenwert (für den jeweils ein Wort mit 8 bit gespeichert ist) korrigiert und zwar jeweils der nächste.

Zur Korrektur eines Amplitudenwerts wird das «Ist-Wort» aus dem RAM 9 mit dem «Soll-Wort» aus dem PROM 3 verglichen. Ist der Ist-Wert kleiner als der Soll-Wert, dann wird das im RAM 6 gespeicherte Wort um 1 Bit vergrössert. Ist der Ist-Wert grösser als der Soll-Wert, dann wird das im RAM 6 gespeicherte Wort um 2 Bit verkleinert.

Eine Verbesserung der Korrektur erreicht man dann, wenn man, wie bei der beschriebenen schnellen Korrektur, zur Korrektur eines bestimmten Amplitudenwerts nicht nur die diesem zugeordnete Differenz sondern auch die Differenz für die nachfolgenden 8 Amplitudenwerte ermittelt. Dadurch machen sich Signallaufzeiten und Verzögerungen von bis zu ca. 1 µs nicht störend bemerkbar.

Sind alle im RAM 9 gespeicherten Amplitudenwerte kleiner als die im PROM 9 gespeicherten Sollwerte, dann wird das Wort für den gerade zu korrigierenden Amplitudenwert im RAM um 1 Bit vergrössert. Ist nur einer dieser Amplitudenwerte grösser als sein entsprechender Wert im PROM 3, dann wird das zu korrigierende Wort im RAM 6 um 2 Bit verkleinert. Nach der Korrektur eines Worts für einen Amplitudenwert wird zur Korrektur des nächsten Worts weitergeschaltet. Sind alle Worte korrigiert, dann beginnt der Korrekturvorgang von vorne.

Bislang wurde davon ausgegangen, dass das Sendesignal aus einem Impuls besteht. Häufig besteht jedoch das Sendesignal aus einem Doppelimpuls (z.B. beim Entfernungsmesssystem DME) oder aus einer Vielzahl von Impulsen oder Impulsgruppen (Navigationssystem TACAN).

In diesen Fällen reicht es nicht mehr aus, nur das Modulationssignal für einen einzelnen Impuls geeignet vorzuverzerren; auch wenn die Impulsgruppe ausschliesslich aus gleichartigen Impulsen besteht. Bei schnell aufeinanderfolgenden Impulsen ändern sich nämlich die elektrischen Parameter der im Verstärker verwendeten Leistungstransistoren. Dies gilt vor allem für die Leistungsverstärkung, die sich mit der Impulsrate ändert. Hierdurch entsteht eine Verzerrung der Pulsform aller weiteren Impulse einer Pulsgruppe.

Zur Korrektur müssen also alle Soll- und Ist-Amplitudenwerte aller Impulse einer Impulsgruppe miteinander verglichen werden.

Für das nachfolgend beschriebene Beispiel wird angenommen, dass die Impulsgruppen aus Doppelimpulsen (2 gleiche Einzelimpulse) bestehen. Zur Realisierung sind mehrere Lösungen geeignet:

1. Im PROM 3 ist ein Doppelimpuls gespeichert. Die zum Vergleich benötigten Worte werden bei Bedarf entsprechend einem Algorithmus, der in einem Mikroprogramm im PROM 3 vorgegeben ist, mittels Adressrechnung der CPU 4 aus dem PROM 3 abgerufen.

2. Im PROM 3 ist nur ein Impuls des Doppelpulses gespeichert. Die beiden Impulse des Doppelimpulses werden mit diesem Sollimpuls verglichen. Hierbei ist es notwendig, dass dieser Sollimpuls exakt zeitsynchron zum Vorhandensein der Impulse des Doppelimpulses ausgelesen wird. Das Auslesen wird durch ein Mikroprogramm im PROM 3 gesteuert. Der Einzel-Soll-Impuls wird also durch mehrfaches aufeinanderfolgendes Auslesen aus PROM 3 mit jeweils einem der beiden Ist-Impulse des Doppelimpulses zur Deckung gebracht.

3. Im PROM 3 ist ein Soll-Impuls gespeichert. Nach dem Einschalten und bei Wechsel der Betriebsart (wenn z.B. anstatt des Doppelimpulses eine andere Impulsgruppe oder ein Doppelimpuls mit geändertem Impulsabstand gesendet wird) wird in einem weiteren RAM 3 durch ein Mikroprogramm das komplette Sollsignal aus dem einzelnen Soll-Impuls gebildet, ohne dass der Verstärker arbeitet.

Unabhängig davon, welche dieser Lösungen gewählt wird, erfolgt die Korrektur analog zur Korrektur, bei der ein nur aus einem einzelnen Impuls bestehendes Sendesignal korrigiert wird.

Bei der beschriebenen Korrektur bleibt gegebenenfalls noch ein Restfehler bestehen, der durch Verzerrungen bei der Auskopplung oder bei der Gleichrichtung verursacht wird. Dieser Fehler beseitigt man dadurch, dass man die Verzerrungen ermittelt und bei der Vorverzerrung des Modulationssignals berücksichtigt.

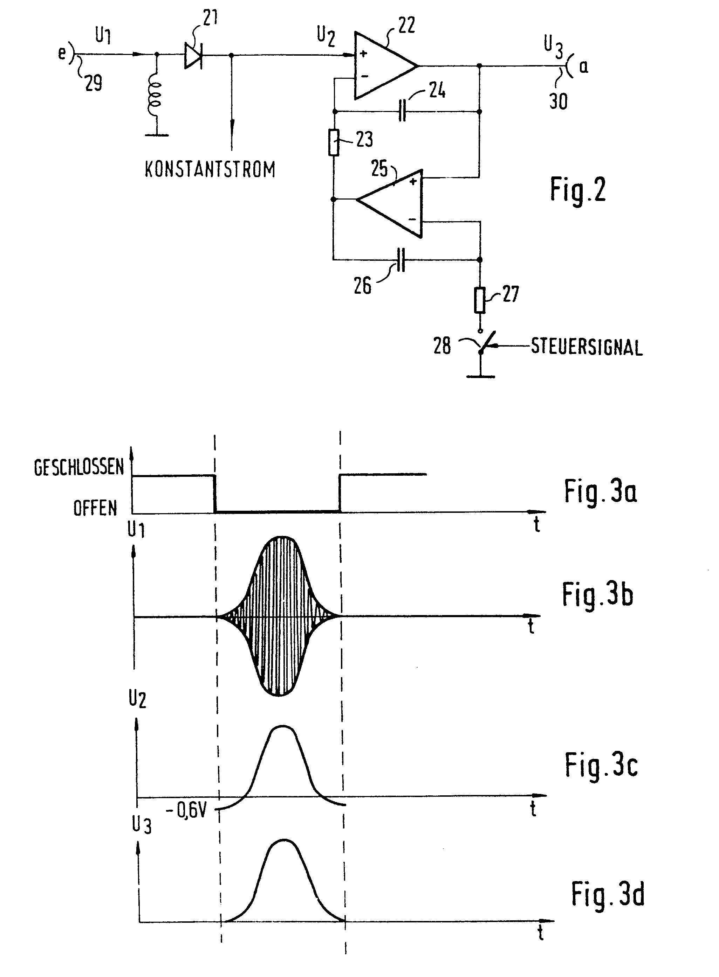

Nachfolgend wird anhand der Fig. 2 und 3 ein Gleichrichter beschrieben, bei dem die Verzerrung minimal gehalten wird.

Das impulsförmige HF-Signal U1 (Fig. 3 b) wird dem Eingang e des Gleichrichters zugeführt und gelangt dann zu einer Diode 21. Als Diode ist der Typ HP 5082-2800 von Hewlett-Packard geeignet.

Durch die Diode wird ein Kontantstrom von ca. 100 μA geschickt.

Das Ausgangssignal der Diode wird zum nichtinvertierenden Eingang eines Operationsverstärkers 22 geleitet. Der Ausgang dieses Operationsverstärkers ist einerseits über einen Kondensator 24 mit dem invertierenden Eingang des Operationsverstärkers 22 und andererseits mit dem nichtinvertierenden Eingang eines weiteren Operationsverstärkers 25 verbunden. Der invertierende Eingang des weiteren Operationsverstärkers 25 ist einerseits über einen Widerstand 27 und einen steuerbaren Schalter 28 auf Masse gelegt und andererseits über einen Kondensator 26 mit dem Ausgang des weiteren Operationsverstärkers verbunden. Der Ausgang des weiteren Operationsversträkers 25 ist ausserdem über einen Widerstand 23 mit dem invertierenden Eingang des ersten Operationsverstärkers 22 verbunden.

Der Ausgang a der Gleichrichterschaltung ist der Ausgang des ersten Operationsverstärkers.

Als Operationsverstärker ist HA 2515 geeignet. Die Widerstände 23 und 27 haben die Werte 10 KΩ und 4,7 kΩ; die Kondensatoren 24 und 26 haben die Werte 0,1 μF und 100 pf.

Wie bereits erwähnt, muss bekannt sein, wann ein impulsförmiges Signal erwartet wird. Während der Zeit, während der ein solches Signal erwartet wird, schliesst ein Steuersignal den Schalter 28 und legt somit den invertierenden Eingang des weiteren Operationsverstärkers 25 auf Masse. Ist die Ausgangsspannung des ersten Operationsverstärkers 22 nicht gleich 0 (was infolge des Diodenkonstantstroms der Fall ist), dann gibt der weitere Operationsverstärker 25 so lang ein Signal ab, bis durch Umladung von Kondensator 24 am Ausgang des ersten Operationsverstärkers die Spannung null entsteht.

Wenn ein impulsförmiges Signal (Fig. 3b) erwartet wird, öffnet das Steuersignal (Fig. 3a) für diese Zeit den Schalter 28. Die Kondensatoren 24 und 26 halten während dieser Zeit angenähert ihre Spannungen.

Das Ausgangssignal U2 der Diode 21 hat den in Fig. 3c angegebenen Verlauf, der die Einhüllende des impulsförmigen HF-Signals, verschoben um die Vorspannung von ca. −0,6 V ist. Bedingt durch die an den Kondensatoren anliegenden Spannungen wird das Signal U2 um + 0,6 v verschoben; man erhält das Signal U3 (Fig. 3d), bei dem die durch den Vorstrom verursachte Fehlspannung kompensiert ist.

**Patentansprüche**

1. Hochfrequenz-Leistungsverstärker mit einer Modulationseinrichtung (5, 8, 10, 15, 16) zur Erzeugung impulsförmiger Signale, bei dem das vorverzerrte analoge Modulationssignal aus mehreren in einem Speicher (6) gespeicherten digitalen Amplitudenwerten, deren Einhüllende das vorverzerrte Modulationssignal ist, abgeleitet wird, bei dem zur Ermittlung der erforderlichen Vorverzerrung ein Teil des analogen modulierten Verstärkerausgangssignals ausgekoppelt (14) und mit einem Sollsignal verglichen wird und bei dem abhängig von diesem Vergleich die gespeicherten digitalen Amplitudenwerte so verändert werden, dass das analoge Modulationssignal so vorverzerrt ist, dass das Verstärkerausgangssignal den gewünschten Verlauf hat, dadurch gekennzeichnet, dass das ausgekoppelte Signal, welches das Ist-Signal ist, digitalisiert (10) wird, so dass es durch mehrere Ist-Amplitudenwerte beschrieben wird, dass das Sollsignal aus mehreren in einem Speicher (3) gespeicherten digitalen Soll-Amplitudenwerten besteht, dass die Differenzen (D) der Ist-Amplitudenwerte und der Soll-Amplitudenwerte gebildet (3, 4) werden, und dass zumindest während der Einregelzeit der Wert, um den ein gespeicherter Amplitudenwert korrigiert wird, bestimmt ist durch die für diesen Amplitudenwert ermittelte Differenz minus einem verstärkerspezifischen Wert (K1), der von der Steilheit der Verstärkerkennlinie bei dem zu korrigierenden Amplitudenwert abhängt, plus der kleinsten der Differenzen (K2) zwischen Ist- und Soll-Amplitudenwerten, die auf den zu korrigierenden Amplitudenwert zeitlich folgen.

2. Hochfrequenz-Leistungsverstärker nach Anspruch 1, dadurch gekennzeichnet, dass in der Zeit zwischen der Aussendung von zwei impulsförmigen Signalen mindestens mehrere der gespeicherten Amplitudenwerte korrigiert werden.

3. Hochfrequenz-Leistungsverstärker nach Anspruch 2, dadurch gekennzeichnet, dass die Korrektur aller gespeicherten Amplitudenwerte parallel gleichzeitig erfolgt.

4. Hochfrequenz-Leistungsverstärker nach einem der Ansprüche 1 bis 3, dadurch gekennzeichnet, dass die Korrektur während der Impulspausen erfolgt.

5. Hochfrequenz-Leistungsverstärker nach einem der Ansprüche 1 bis 4, dadurch gekennzeichnet, dass bei der Bestimmung des Werts, um den ein gespeicherter Amplitudenwert korrigiert wird, der Fehler berücksichtigt wird, der bei der Ermittlung (8) der Einhüllenden des ausgekoppelten Signals entsteht.

6. Hochfrequenz-Leistungsverstärker nach einem der Ansprüche 1 bis 5, dadurch gekennzeichnet, dass das vom Hochfrequenz-Leistungsverstärker (7) abgegebene Signal aus mindestens einer Impulsgruppe besteht und dass für alle Amplitudenwerte der Impulse einer Impulsgruppe eine entsprechende Korrektur durchgeführt wird.

7. Hochfrequenz-Leistungsverstärker nach einem der Ansprüche 1 bis 6, dadurch gekennzeichnet, dass dann, wenn das Verstärkerausgangssignal angenähert seine Sollform erreicht hat, bei einem einzelnen Korrekturvorgang nur noch jeweils der Wert für eine gespeicherte Amplitude korrigiert wird.

8. Hochfrequenz-Leistungsverstärker nach einem der Ansprüche 1 bis 7, dadurch gekennzeichnet, dass zur Ermittlung der Einhüllenden des Ausgangssignals des Hochfrequenz-Leistungsverstärkers ein Gleichrichter (8) vorgesehen ist, der eine Diode (21), durch die ein konstanter Vorstrom geschickt wird, enthält, dass der Ausgang der Diode mit dem nicht invertierenden Eingang eines ersten Operationsverstärkers (22) verbunden ist, dass der Ausgang dieses Operationsverstärkers einerseits der Ausgang (a) des Gleichrichters ist und andererseits über einen Kondensator (24) mit dem invertierenden Eingang des ersten Operationsverstärkers bzw. mit dem nicht invertierenden Eingang eines zweiten Operationsverstärkers (25) verbunden ist, dass der invertierende Eingang des zweiten Operationsverstärkers über einen Wiederstand (27) und einen Schalter (28) auf Masse gelegt bzw. über einen Kondensator (26) mit dem Ausgang des zweiten Operationsverstärkers verbunden ist, dass der Ausgang des zweiten Operationsverstärkers ausserdem über einen Widerstand (23) mit dem invertierenden Eingang des ersten Operationsverstärkers verbunden ist, und dass der Schalter (28) so gesteuert wird, dass er nur während der Zeit, während der ein impulsförmiges Signal erwartet wird, geöffnet ist.

**Claims**

1. High-frequency power amplifier with a modulating facility (5, 8, 10, 15, 16) for generating pulse signals wherein the pre-emphasized analog modulating signal is derived from a plurality of digital amplitude values which are stored in a memory (6) and whose envelope is the pre-emphasized modulation signal, wherein, for the purpose of determining the necessary pre-emphasis, a portion of the analog modulated amplifier output signal is extracted (14) and compared with a reference signal and wherein, depending on the result of the comparison, the stored digital amplitude values are altered to provide such a pre-emphasis for the analog modulation signal that the amplifier output signal has the desired shape, characterized in that the extracted signal, which is the actual signal, is digitalized (10) so as to be described by a plurality of actual amplitude values, that the reference signal consists of a plurality of digital reference amplitude values stored in a memory (3), that the differences (D) between the actual amplitude values and the reference amplitude values are formed (3, 4) and that, at least during the adjustment time, the value by which a stored amplitude value is corrected is determined by the difference found for this amplitude value minus an amplifier-specific value (K1) which depends on the slope of the amplifier characteristic at the amplitude value to be corrected plus the least of those differences (K2) between the actual and reference amplitude values which chronologically follow the amplitude value to be corrected.

2. A radio-frequency power amplifier as claimed in Claim 1, characterized in that, during the time between the transmission of two pulse signals, at least several of the stored amplitude values are corrected.

3. A radio-frequency power amplifier as claimed in Claim 2, characterized in that all stored amplitude values are corrected in parallel simultaneously.

4. A radio-frequency power amplifier as claimed in any one of Claims 1 to 3, characterized in that the correction is performed during the intervals between pulses.

5. A radio-frequency power amplifier as claimed in any one of Claims 1 to 4, characterized in that the determination of the value by which a stored amplitude value is corrected allows for the error arising during the determination (8) of the envelope of the extracted signal.

6. A radio-frequency power amplifier as claimed in any one of Claims 1 to 5, characterized in that the signal delivered by the radio-frequency power amplifier (7) consists of at least one pulse group and that a corresponding correction is performed for all amplitude values of the pulses of a pulse group.

7. A radio-frequency power amplifier as claimed in any one of Claims 1 to 6, characterized in that, when the amplifier output signal has reached approximately its desired shape, only the value of one stored amplitude is corrected in each correcting operation.

8. A radio-frequency power amplifier as claimed in any one of Claims 1 to 7, characterized in that the envelope of the output signal of the radio-frequency power amplifier is determined with a rectifier (8) containing a diode (21) through which a constant preconduction current is sent, that the output of the diode is connected to the non-inverting input of a first operational amplifier (22) having its output coupled on the one hand to the output (a) of the rectifier and on the other hand, via a capacitor (24), to the inverting input of the first operational amplifier and to the non-inverting input of a second operational amplifier (25), that the inverting input of the second operational amplifier is earthed via a resistor (27) and a switch (28) and connected, via a capacitor (26), to the output of the second operational amplifier, that the output of the second operational amplifier is also connected to the inverting input of the first operational amplifier via a resistor (23) and that the switch (28) is controlled in such a way as to be open only during the time when a pulse signal is expected.

**Revendications**

1. Amplificateur de puissance pour hautes fréquences comportant un dispositif de modulation (5, 8, 10, 15, 16), pour engendrer des impulsions de signal dans lequel le signal de modulation analogique pré-accentué est dérivé de plusieurs valeurs d'amplitude numériques enregistrées dans une mémoire (6), dont l'enveloppe constitue le signal de modulation pré-accentué, une partie du signal de sortie analogique modulé de l'amplificateur étant extraite (14), pour la détermination de la pré-accentuation nécessaire, laquelle est comparée à un signal de référence et les valeurs d'amplitude numériques enregistrées étant modifiées en fonction de cette comparaison de manière que le signal analogique de modulation reçoive une pré-accentuation telle que le signal de sortie de l'amplificateur ait la forme souhaitée, caractérisé en ce que le signal extrait, qui est le signal réel, est converti sous forme numérique (10) de manière à etre décrit par plusieurs valeurs d'amplitudes réelles, tandis que le signal de référence est constitué de plusieurs valeurs d'amplitude de référence numériques enregistrées dans une mémoire (3), les différences (D) entre valeur d'amplitude réelle et valeur d'amplitude de référence étant établies (3, 4), et en ce que, au moins durant le temps de réglage, la valeur par laquelle une valeur d'amplitude enregistrée doit etre corrigée est déterminée par la différence trouvée pour cette valeur d'amplitude, diminuée d'une valeur spécifique de l'amplificateur (K1), laquelle dépend de la pente de la caractéristique de l'amplificateur à la valeur d'amplitude à corriger, et augmentée de la plus petite des différences (K2) entre les valeurs d'amplitude réelle et de référence qui suivent dans le temps la valeur d'amplitude à corriger.

2. Amplificateur de puissance pour hautes fréquences selon la revendication 1, caractérisé en ce que, durant l'intervalle de temps s'étendant entre la transmission de deux impulsions de signal, plusieurs au moins des valeurs d'amplitudes enregistrées sont corrigées.

3. Amplificateur de puissance pour hautes fréquences selon la revendication 2, caractérisé en ce que la correction s'effectue en parallèle, simultanément pour toutes les valeurs d'amplitudes enregistrées.

4. Amplificateur de puissance pour hautes fréquences selon les revendications 1 à 3, caractérisé en ce que la correction s'effectue durant les intervalles entre impulsions.

5. Amplificateur de puissance pour hautes fréquences selon les revendications 1 à 4, caractérisé en ce que, dans la détermination de la valeur par laquelle est corrigée une valeur d'amplitude enregistrée, on tient compte de l'erreur entrant dans la détermination (8) de l'enveloppe du signal extrait.

6. Amplificateur de puissance pour hautes fréquences selon les revendications 1 à 5, caractérisé en ce que le signal fourni par l'amplificateur de puissance pour hautes fréquences (7) consiste en au moins un groupe d'impulsions et en ce qu'une correction correspondante est effectuée pour toutes les valeurs d'amplitude des impulsions d'un groupe d'impulsions.

7. Amplificateur de puissance pour hautes fréquences selon les revendications 1 à 6, caractérisé en ce que, lorsque le signal de sortie de l'amplificateur a atteint approximativement la forme désirée, une valeur d'amplitude enregistrée seulement est corrigée dans chaque opération de correction.

8. Amplificateur de puissance pour hautes fréquences selon les revendications 1 à 7, caractérisé en ce que l'enveloppe du signal de sortie de l'amplificateur de puissance pour hautes fréquences est déterminée à l'aide d'un redresseur (8) comprenant une diode (21) à travers laquelle passe un courant constant de polarisation, la sortie de cette diode étant connectée à l'entrée non inverseuse d'un premier amplificateur opérationnel (22) dont la sortie, d'une part, constitue la sortie (a) du redresseur et, d'autre part, est connectée par l'intermédiaire d'un condensateur (24), à l'entrée inverseuse du premier amplificateur opérationnel et à l'entrée non inverseuse d'un deuxième amplificateur opérationnel (25) dont l'entrée inverseuse est connectée à la: masse par l'intermédiaire d'une résistance (27) et d'un commutateur (28) et est connectée à sa sortie par un condensateur (26), la sotie du deuxième amplificateur opérationnel étant également connectée à l'entrée inverseuse du premier amplificateur opérationnel par uyn résistance (23), et le commutateur étant commandé de sorte qu'il est ouvert seulement pendant le temps durant lequel est attendu un signal d'impulsions.

0 096 820

Fig.1

9

KONSTANTSTROM

Fig.2

Fig.3a

GESCHLOSSEN

OFFEN

U1

Fig.3b

U2

Fig.3c

−0,6V

U3

Fig.3d